(19) Europäisches Patentamt / European Patent Office / Office européen des brevets

(11) **EP 1 416 498 B1**

(12) **FASCICULE DE BREVET EUROPEEN**

(45) Date de publication et mention
de la délivrance du brevet:
**08.08.2007 Bulletin 2007/32**

(51) Int Cl.:
***G11C 17/16*** *(2006.01)*    *G11C 7/06* *(2006.01)*
*G01C 22/02* *(2006.01)*

(21) Numéro de dépôt: **03300159.5**

(22) Date de dépôt: **16.10.2003**

(54) **Compteur monotone à base de cellules mémoire**

Auf Speicherzellen basierter monotoner Zähler

Monotonous counter based on memory cells

(84) Etats contractants désignés:
**DE FR GB IT**

(30) Priorité: **28.10.2002 FR 0213458**

(43) Date de publication de la demande:
**06.05.2004 Bulletin 2004/19**

(73) Titulaire: **STMicroelectronics S.A.**
**92120 Montrouge (FR)**

(72) Inventeur: **Wuidart, Luc**
**83910 Pourrieres (FR)**

(74) Mandataire: **de Beaumont, Michel**
**1bis, rue Champollion**
**38000 Grenoble (FR)**

(56) Documents cités:
**DE-A- 10 101 575       US-A- 4 399 372**
**US-A- 4 559 637       US-A- 5 418 738**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention concerne le domaine des compteurs et, plus particulièrement, les compteurs monotones dont la variation du compte est irréversible et dans un seul sens.

Aujourd'hui, pour réaliser des compteurs monotones croissants, on est contraint d'utiliser des éléments fusibles qui présentent l'inconvénient notable de conduire à une programmation destructrice souvent incompatible avec une programmation au cours de fonctionnement du circuit intégré contenant l'élément fusible. Un autre exemple concerne les mémoires EPROM ou EEPROM dont la fabrication requiert des étapes non directement compatibles avec une technologie CMOS.

De plus, dans les deux cas, l'état de programmation réalisé est soit effaçable (cas des EEPROM) soit visible optiquement, ce qui est préjudiciable dans des applications de type sécuritaire pour lesquelles on souhaite disposer d'un compte inviolable.

Un exemple d'application consiste à compter le nombre d'événements par rapport à un seuil limite d'événements (nombre d'utilisations d'un programme ou durée d'utilisation). Dans ce type d'application, on souhaite généralement disposer d'un compteur dont chaque bit prend successivement les états 0 ou 1 de façon irréversible pour fournir un mot binaire représentatif du nombre d'événements apparus. Par exemple, il peut s'agir de compter le nombre d'accès à une mémoire de type flash. Dans cette application, pour remplir cette fonction de comptage par une mémoire flash elle-même, on doit monopoliser une surface très importante de la mémoire dans la mesure où la "granularité", c'est-à-dire le nombre minimal de cellules que l'on doit adresser pour une programmation irréversible, est importante. En pratique, pour utiliser en mémoire à programmation unique une région d'une mémoire flash, on doit réserver une capacité de l'ordre du kilobit pour obtenir huit bits de mémoire à programmation unique.

Les autres techniques de cellules mémoire à programmation unique qui seraient susceptibles d'être utilisées dans des opérations de comptage monotone sont en pratique inexploitables. Par exemple, les cellules de type fusible ou anti-fusible requièrent des programmations par des courants destructeurs qui sont souvent incompatibles avec le produit en cours de fonctionnement.

Le document US-A-4 559 637 décrit un compteur monotone (compteur pour voiture) dont le contenu est rendu irréversible par le stockage d'un bit dans une mémoire PROM du type à fusible chaque fois que le compteur est incrémenté.

Le document US-A-5 418 738 décrit une mémoire redondante utilisant une cellule mémoire ayant des résistances programmables de structure à silicium polycristallin.

La présente invention vise à proposer un compteur monotone qui pallie les inconvénients des compteurs classiques.

L'invention vise notamment à proposer une solution qui ne requiert pas de monopoliser une surface d'une mémoire flash importante pour remplir une fonction de compteur à programmation unique.

L'invention vise également à proposer une solution pour réaliser un compteur monotone dont le comptage soit compatible avec le fonctionnement d'un circuit intégré.

L'invention vise également à proposer la réalisation d'un compteur monotone en utilisant des technologies classiques de fabrication de type MOS.

Pour atteindre ces objets et d'autres, la présente invention prévoit un compteur monotone réalisé en circuit intégré, chaque bit de comptage étant fourni par une cellule mémoire contenant au moins un élément de mémorisation constitué d'une résistance en silicium polycristallin, programmable par diminution irréversible de sa valeur, rendant la variation du comptage irréversible.

Selon un mode de réalisation de la présente invention, la programmation de ladite résistance est effectuée en la soumettant temporairement à un courant de contrainte supérieur à un courant pour lequel sa valeur présente un maximum.

Selon un mode de réalisation de la présente invention, le compteur comporte un circuit de décodage des états contenus dans lesdites cellule mémoire pour fournir le compte résultant.

Selon un mode de réalisation de la présente invention, chaque cellule comporte, en parallèle entre deux bornes d'application d'une tension d'alimentation, deux branches comprenant chacune

une première résistance de programmation en silicium polycristallin, connectée entre une première borne d'alimentation et une borne de lecture différentielle de l'état de la cellule mémoire ; et chaque cellule mémoire comprend

au moins un interrupteur de programmation reliant une desdites bornes de lecture à la deuxième borne d'alimentation.

Selon un mode de réalisation de la présente invention, chaque branche comporte un interrupteur de programmation.

Selon un mode de réalisation de la présente invention, lesdites résistances de programmation sont deux résistances en silicium polycristallin identiques en taille et en dopage éventuel.

Selon un mode de réalisation de la présente invention, chaque cellule mémoire comporte un transistor de programmation en série avec une résistance de programmation.

Selon un mode de réalisation de la présente invention, le compteur comporte en outre un cirçuit de commande en programmation de chacune des cellules mémoire propre à fournir des signaux de commande individuels aux interrupteurs de programmation.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 illustre, par une vue partielle en perspective, un mode de réalisation d'une résistance en silicium polycristallin constituant l'élément de mémorisation d'une cellule de comptage selon l'invention ;
la figure 2 illustre, par un réseau de courbes, la programmation d'une cellule telle qu'illustrée par la figure 1 ;
la figure 3 représente un premier mode de réalisation d'une cellule de comptage selon la présente invention ;
la figure 4 représente un deuxième mode de réalisation d'une cellule de comptage selon la présente invention ;
la figure 5 représente un troisième mode de réalisation d'une cellule de comptage selon la présente invention ;
la figure 6 représente un mode de réalisation d'un circuit de décodage d'un compteur quatre bits selon la présente invention ; et
la figure 7 illustre un exemple d'application d'un compteur de l'invention à un circuit utilisant une mémoire flash.

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, l'exploitation faite des résultats de comptage n'a pas nécessairement été détaillée, l'invention pouvant être mise en oeuvre quelle que soit la destination du résultat de comptage pourvu que l'on souhaite un compte monotone irréversible.

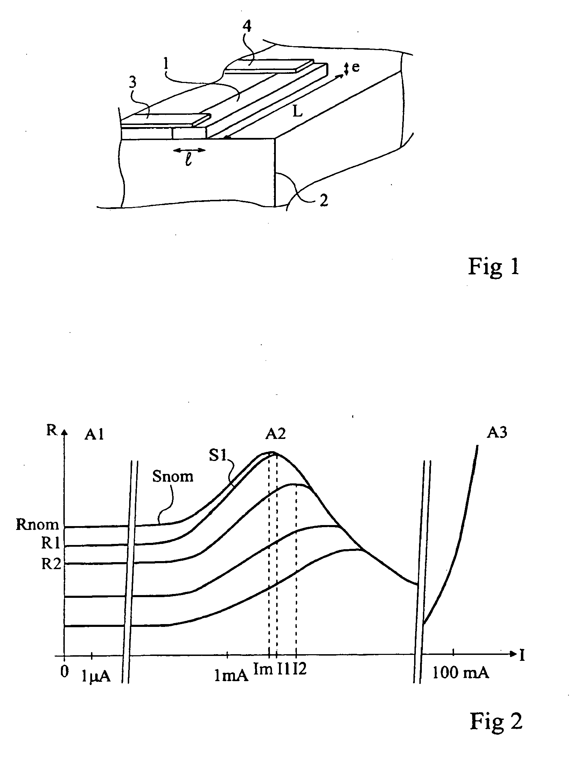

Une caractéristique de la présente invention est de réaliser un compteur monotone à partir d'autant de cellules de comptage que le compteur comprend de bits. De plus, selon l'invention, l'élément de mémorisation de chaque cellule de comptage est constitué d'une résistance en silicium polycristallin à programmation par diminution irréversible de sa valeur. Cette caractéristique de l'invention ressortira de l'exposé des figures 1 et 2 qui va suivre et qui illustre les possibilités de programmation d'une résistance en silicium polycristallin exploitées par l'invention.

La figure 1 représente, par une vue partielle très schématique en perspective, un exemple de résistance en silicium polycristallin du type de celle utilisée dans une cellule de comptage selon l'invention.

Une telle résistance 1 est constituée d'une piste (dite aussi barreau) en silicium polycristallin obtenue par gravure d'une couche déposée sur un substrat 2 isolant. Le substrat 2 est indifféremment directement constitué du substrat du circuit intégré ou est constitué d'une couche isolante formant un substrat isolant ou équivalent pour la résistance 1. La résistance 1 est connectée, par ses deux extrémités, à des pistes conductrices (par exemple, métalliques) 3 et 4 destinées à raccorder le barreau résistif aux autres éléments du circuit intégré en fonction de l'application. La représentation schématique de la figure 1 ne fait pas référence aux différentes couches isolantes et conductrices constituant généralement le circuit intégré. Pour simplifier, on s'est contenté de représenter le barreau résistif 1 posé sur le substrat isolant 2 et en contact, par les extrémités de sa face supérieure, avec les deux pistes métalliques 3 et 4. En pratique, les liaisons de l'élément résistif 1 aux autres composants du circuit intégré sont obtenues par des pistes plus larges en silicium polycristallin partant des extrémités du barreau 1 dans l'alignement de celui-ci. En d'autres termes, l'élément résistif 1 est généralement formé en rendant un tronçon d'une piste en silicium polycristallin plus étroit que le reste de la piste.

La résistance R de l'élément 1 est donnée par la formule suivante :

$$R = \rho(L/s),$$

où $\rho$ désigne la résistivité du matériau (silicium polycristallin le cas échéant dopé) constituant la piste dans laquelle est gravé l'élément 1, où L désigne la longueur de l'élément 1, et où s désigne sa section, c'est-à-dire sa largeur 1 par son épaisseur e. La résistivité $\rho$ de l'élément 1 dépend, entre autre, du dopage éventuel du silicium polycristallin le constituant. Dans certains cas, on recouvre l'élément de silicium polycristallin par une couche de métal, l'élément résistif combinant alors le silicium polycristallin et le métal sur-jacent.

Le plus souvent, lors de la réalisation d'un circuit intégré, on prévoit les résistances en faisant référence à une notion dite de résistance par carreau $R_\square$ (square résistance). Cette résistance par carreau se définit comme étant la résistivité du matériau divisée par l'épaisseur avec laquelle il est déposé. En reprenant la relation ci-dessus donnant la résistance d'un élément 1, la résistance est donc donnée par la relation :

$$R = R_\square * L/1.$$

Le quotient L/1 correspond à ce que l'on appelle le nombre de carreaux (square number) constituant l'élément résistif 1. Cela représente, vu de dessus, le nombre de carreaux de dimension donnée fonction de la technologie, mis côte à côte pour former l'élément 1.

La valeur de la résistance en silicium polycristallin est donc définie, à la fabrication, d'après les paramètres ci-dessus. Généralement, l'épaisseur e du silicium polycristallin est fixée par d'autres paramètres de fabrication du circuit intégré. Par exemple, cette épaisseur est fixée par l'épaisseur souhaitée pour les grilles des transistors MOS du circuit intégré.

Dans les technologies récentes, le recours à des résistances en silicium polycristallin est limité aux résistances devant être traversées, en fonctionnement, par des courants inférieurs à 100 $\mu$A. Pour des courants supérieurs, on utilise généralement une résistance de diffusion. Le silicium polycristallin est toutefois préféré à une diffusion de dopants, car on évite l'apparition de capacités parasites avec le substrat.

Pour diminuer irréversiblement la valeur d'une résistance en silicium polycristallin, on impose temporairement un courant dit de contrainte pour lequel la résistance passe par une valeur maximale, ce courant étant au-delà de la plage de courants de fonctionnement normal de cette résistance. En d'autres termes, on diminue la résistivité du silicium polycristallin dans la plage de courants de fonctionnement, de façon stable et irréversible, en imposant dans l'élément résistif correspondant la circulation d'un courant au-delà de la plage de courants de fonctionnement.

Le courant servant à diminuer la valeur de la résistance est, à la différence d'un élément fusible, non destructif pour l'élément en silicium polycristallin.

La figure 2 illustre, par un réseau de courbes donnant la résistance d'un élément en silicium polycristallin du type de celui représenté en figure 1 en fonction du courant le traversant, la façon de diminuer la résistance de cet élément.

On suppose que le silicium polycristallin ayant servi à la fabrication de l'élément résistif 1 présente une résistivité nominale conférant à l'élément 1, pour les dimensions 1, L et e données, une valeur de résistance $R_{nom}$. Cette valeur nominale (d'origine) de la résistance correspond à la valeur prise de façon stable par l'élément résistif 1 dans la plage de courants de fonctionnement du système, c'est-à-dire généralement pour des courants inférieurs à 100 $\mu$A.

Pour diminuer la valeur de la résistance et passer, par exemple, de façon irréversible et stable à une valeur R1 inférieure à $R_{nom}$, on applique aux bornes de l'élément résistif 1 un courant (par exemple I1), dit de contrainte, supérieur à un courant Im pour lequel la valeur de la résistance R de l'élément 1 est maximale sans toutefois être infinie. Comme l'illustre la figure 2, une fois que ce courant I1 a été appliqué à l'élément résistif 1, on obtient, dans la plage A1 de courants de fonctionnement du circuit intégré, une résistance stable de valeur R1. En fait, l'allure $S_{nom}$ de la résistance en fonction du courant est stable pour des courants relativement faibles (inférieurs à 100 $\mu$A). Cette allure se met à croître pour des courants sensiblement supérieurs de l'ordre de quelques milliampères, voire plus (plage A2). C'est dans cette plage de courants que l'allure Snom passe par un maximum pour la valeur Im. La résistance décroît ensuite progressivement. En figure 2, on a illustré une troisième plage A3 de courants correspondant à la plage généralement utilisée pour réaliser des fusibles. Il s'agit de courants de l'ordre du dixième d'ampère où la résistance se met à croître brusquement jusqu'à devenir infinie. Par conséquent, on peut considérer que l'invention utilise la plage intermédiaire A2 de courants entre la plage de fonctionnement A1 et la plage destructrice A3, pour diminuer de façon irréversible la valeur de la résistance ou plus précisément de la résistivité de l'élément en silicium polycristallin.

En effet, une fois passé le maximum de l'allure Snom de la résistivité en fonction du courant, la valeur prise par la résistance dans la plage de courants de fonctionnement se trouve inférieure à la valeur $R_{nom}$. La nouvelle valeur, par exemple R1, dépend de la valeur la plus élevée du courant (ici, I1) qui a été appliqué pendant la phase de diminution irréversible. On notera en effet que la diminution irréversible opérée par l'invention s'effectue dans une phase spécifique, hors du fonctionnement normal (plage AI) du circuit intégré, c'est-à-dire hors du fonctionnement normal de la résistance.

Une fois que la valeur de la résistance en silicium polycristallin a été abaissée vers une valeur inférieure (par exemple R1 en figure 2), on peut encore procéder à une diminution irréversible de cette valeur. Il suffit pour cela de dépasser le courant maximum I1 de la nouvelle allure S1 de la résistance en fonction du courant. Par exemple, on peut accroître la valeur du courant jusqu'à atteindre une valeur 12. Quand le courant est alors de nouveau diminué, on obtient une valeur R2 pour la résistance dans sa plage de fonctionnement normal. La valeur R2 est inférieure à la valeur R1 et, bien sûr, à la valeur $R_{nom}$.

On voit que toutes les allures de la résistance en fonction du courant se rejoignent sur la pente de décroissance de la valeur de la résistance, après être passées par le maximum de l'allure. Ainsi, pour un élément résistif donné (p, L, s), les courants I1, I2, etc. qui doivent être atteints, pour passer à une valeur de résistance inférieure, sont indépendants de la valeur de la résistance (Rnom, R1, R2) à partir de laquelle on provoque la diminution.

Ce qui a été exprimé ci-dessus comme valeur de résistance correspond en fait à une diminution de la résistivité du silicium polycristallin constituant l'élément résistif. Les inventeurs considèrent que l'on assiste à une modification stable de la structure cristalline du silicium polycristallin et que l'on assiste, en quelque sorte, à un fluage du matériau, la structure cristalline finale obtenue dépendant du courant maximum atteint. En fait, le courant de contrainte provoque une élévation de température de l'élément en silicium, ce qui entraîne un fluage de celui-ci.

Bien sûr, on veillera à ne pas dépasser la plage de courants de paramétrage A2 (de l'ordre de quelques milliampères) afin de ne pas risquer de détruire la résistance en silicium polycristallin. Cette précaution ne posera en pratique pas de problème dans la mesure où l'utilisation du silicium polycristallin pour constituer un fusible requiert des courants nettement plus élevés (de l'ordre du dixième d'ampère) qui ne sont pas disponibles une fois le circuit fabriqué.

La réalisation pratique d'une résistance en silicium polycristallin ne diffère pas de la réalisation d'une résistance classique. Partant d'un substrat isolant, on dépose une couche de silicium polycristallin que l'on grave en fonction des dimensions souhaitées pour la résistance. Comme l'épaisseur de silicium polycristallin déposée est généralement fixée par la technologie, les deux dimensions que l'on peut régler sont la largeur et la longueur. Généralement, on redépose un isolant sur le barreau de silicium polycristallin ainsi obtenu. Dans le cas d'une interconnexion en ligne, on aura modifié la largeur 1 par rapport aux pistes d'accès plus larges pour être fortement conductrices. Dans le cas d'un accès aux extrémités du barreau par le dessus comme cela est illustré en figure 1, on réalisera des vias dans l'isolant sur-jacent (non représenté) du barreau de silicium polycristallin pour connecter des pistes métalliques 3 et 4 de contact.

En pratique, pour disposer de la capacité de réglage de résistance la plus importante avec un courant de contrainte minimum, on cherchera à utiliser une épaisseur minimale et une largeur minimale pour les éléments résistifs. Dans ce cas, seule la longueur L conditionne la valeur nominale de la résistance une fois la structure du silicium polycristallin fixée. Le dopage éventuel du silicium polycristallin, quel que soit son type, n'entrave pas la mise en oeuvre de l'invention. La seule différence liée au dopage est la résistivité nominale avant contrainte et les résistivités obtenues pour des courants de contraintes donnés. En d'autres termes, pour un élément de dimensions données, cela conditionne le point de départ de la valeur de la résistance, et par voie de conséquence, les valeurs de résistance obtenues pour des courants de contrainte donnés.

Pour passer de la valeur nominale à une valeur de résistance ou résistivité inférieure, ou pour passer d'une valeur donnée (inférieure à la valeur nominale) à une valeur encore inférieure, on peut utiliser plusieurs méthodes.

Par exemple, on fait croître progressivement (pas à pas) le courant dans la résistance. Après chaque application d'un courant supérieur, on revient dans la plage de courants de fonctionnement et on mesure la valeur de la résistance. Tant que le point Im de courant n'est pas atteint, cette valeur de résistance restera à la valeur $R_{nom}$. Dès que le point Im en courant est dépassé, on change de courbe (allure S) et la valeur mesurée lorsque l'on repasse sur les courants de fonctionnement devient une valeur inférieure à la valeur $R_{nom}$. Si cette nouvelle valeur convient, on en reste là. Dans le cas contraire, on réapplique des courants supérieurs pour dépasser la nouvelle valeur maximale de l'allure courante. Dans ce cas, il n'est pas nécessaire de repartir des courants minimaux comme lorsque l'on démarre de la résistance nominale. En effet, la valeur du courant pour laquelle la résistance va de nouveau diminuer est forcément supérieure à la valeur du courant de contrainte I1 appliqué pour passer sur l'allure courante. La détermination du pas à appliquer est à la portée de l'homme du métier et n'est pas critique en ce qu'elle conditionne essentiellement le nombre de diminutions possibles. Plus le pas est élevé, plus les sauts entre les valeurs seront importants.

Selon un autre exemple préféré, on prédétermine, par exemple par mesures, les différents courants à appliquer pour passer des différentes valeurs de résistance à des valeurs inférieures. Cette prédétermination tient compte bien entendu de la nature du silicium polycristallin utilisé ainsi que préférentiellement de la résistance par carreau c'est-à-dire de la résistivité du matériau et de l'épaisseur dans laquelle il est déposé. En effet, comme les allures illustrées par la figure 2 peuvent également être lues comme allure de la résistance par carreau, on est en mesure de transposer les valeurs calculées aux différentes résistances d'un circuit intégré définies par les largeurs et longueurs des tronçons résistifs. Selon ce deuxième mode de mise en oeuvre, on est alors en mesure de prédéterminer la valeur du courant de contrainte à appliquer à l'élément résistif pour diminuer, de façon irréversible et stable, sa valeur.

Le changement de courbes, c'est-à-dire la diminution de la valeur de résistance en fonctionnement normal est quasi immédiate dès que le courant de contrainte correspondant est appliqué. Par quasi-immédiat, on entend une durée de quelques dizaines voir centaines de microsecondes qui suffisent pour appliquer la contrainte correspondante au barreau de silicium polycristallin et diminuer la valeur de sa résistance. Cette valeur empirique dépend de la taille (physique) du barreau. On pourra choisir une durée de quelques millisecondes par sécurité. De plus, on peut considérer que, une fois la durée minimale atteinte, toute durée supplémentaire d'application du courant de contrainte ne modifie pas, au moins au premier ordre, la résistance atteinte. En outre, même si dans une application particulière on considère ne pas pouvoir négliger l'influence de la durée d'application de la contrainte, les deux méthodes sont parfaitement compatibles avec la prise en compte de la durée d'application de la contrainte.

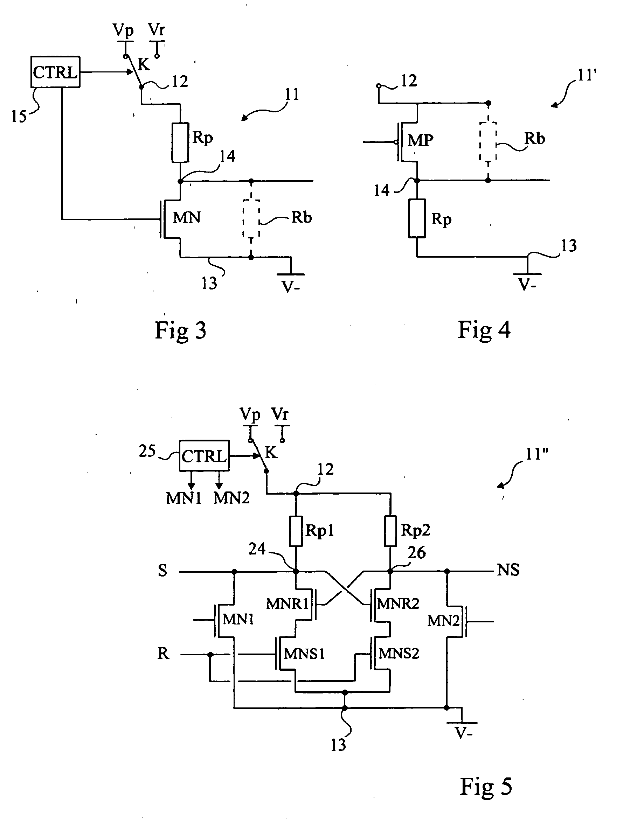

La figure 3 représente un premier mode de réalisation d'une cellule de comptage à programmation unique (ou cellule mémoire) selon l'invention.

La cellule 11 comporte, en série avec une première borne 12 d'application d'un potentiel positif d'alimentation et une deuxième borne 13 d'application d'un potentiel plus négatif d'alimentation V- ou de référence (généralement, la masse), une résistance programmable Rp par diminution irréversible telle que décrite ci-dessus en relation avec les figures 1 et 2 et un interrupteur de programmation ici un transistor MOS à canal N (MN). La résistance Rp constitue l'élément de mémorisation de la cellule 11. L'état stocké dans cette cellule est lu sur le point milieu 14 de l'association en série de la résistance Rp avec le transistor MN. La lecture du niveau mémorisé s'effectue par comparaison par rapport à un niveau de référence.

Pour permettre la lecture de l'état mémorisé dans la cellule 11, on prévoit une résistance Rb (représenté en pointillés en figure 3) qui, lorsque le transistor MN est ouvert constitue avec la résistance Rp un pont diviseur de tension. La résistance Rb a été représentée en pointillés pour illustrer son caractère optionnel. En effet, celle-ci pourra être constituée par le transistor MN alors polarisé dans une partie linéaire de sa caractéristique et non en saturation.

Le transistor MN, lorsqu'il est passant, court-circuite (au moins fonctionnellement) la résistance fixe Rb et sert à programmer la résistance Rp en imposant la circulation d'un courant dans celle-ci. Le courant de programmation de la résistance Rp est supérieur au courant pour lequel cette résistance présente une valeur maximale déterminée comme cela a été exposé précédemment en relation avec les figures 1 et 2.

La plage nominale des courants de fonctionnement d'une résistance en silicium polycristallin utilisée selon l'invention est inférieure à la centaine de microampères et, le plus souvent, inférieure à la dizaine de microampères. L'amplitude des courants de programmation est de l'ordre du milliampère.

La programmation d'une cellule telle qu'illustrée par la figure 3 est rendue possible en prévoyant une sélection du potentiel positif d'alimentation appliqué à la borne 12 entre un potentiel Vr de lecture (propre à engendrer un courant de l'ordre du microampères) et un potentiel Vp de programmation (propre à engendrer un courant de l'ordre du milliampères). La sélection est opérée au moyen d'un interrupteur K commandé par un circuit 15 de commande (CTRL) fournissant par ailleurs le signal de commande adapté au transistor MN.

L'opération de comptage consiste à provoquer la diminution irréversible de la valeur de la résistance Rp en lui appliquant un courant de contrainte. En lecture, la comparaison du potentiel d'une cathode par rapport à une valeur de référence permet de déterminer si la cellule de comptage contient un état 0 ou un état 1.

La figure 4 représente un deuxième mode de réalisation d'une cellule de comptage 11' selon l'invention. Cette cellule diffère de la cellule de la figure 3 par le fait que le transistor de programmation MP utilisé est un transistor MOS à canal P. Le transistor MP est connecté entre la borne 12 et le point 14 de lecture. La résistance de programmation Rp est connectée entre le point 14 et la borne 13 d'application du potentiel de référence. En figure 4, l'interrupteur K et le circuit de commande 15 bien que toujours présents, n'ont pas été représentés. La résistance Rb en pointillés a été symbolisée en parallèle sur le transistor MP.

Le fonctionnement d'une cellule 11' telle que représentée en figure 4 est similaire à celui de la cellule 11 de la figure 3. Cette dernière constitue cependant un mode de réalisation préféré en raison du moindre encombrement du transistor MOS à canal N par rapport au transistor MOS à canal P.

La figure 5 représente un troisième mode de réalisation d'une cellule 11" de comptage irréversible selon la présente invention. La différence essentielle par rapport aux cellules de comptage représentées aux figures 3 et 4 est que la structure de la figure 5 est une structure différentielle ne recourant donc pas de potentiel de référence pour effectuer la comparaison permettant de détecter l'état stocké dans la cellule.

La cellule 11" de la figure 5 comporte deux branches résistives en parallèle entre deux bornes 12 et 13 d'alimentation, deux interrupteurs de programmation MN1 et MN2 (dans cet exemple, des transistors MOS à canal N), un circuit de commande 25 (CTRL) et un sélecteur K entre deux tensions d'alimentation, respectivement de lecture Vr et de programmation Vp. La programmation d'une cellule telle qu'illustrée par la figure 5 s'effectue de façon similaire à celle des cellules des figures 3 et 4. Ce qui change ici, c'est la structure de la cellule pouvant permettre la lecture.

Dans le mode de réalisation de la figure 5, une première branche, dite gauche dans l'orientation de la figure comporte en série, une première résistance Rp1, un transistor MOS de lecture MNR1, et un transistor MOS de sélection MNS1. L'interconnexion entre la résistance Rp1 et le transistor MNR1 constitue une première borne S de sortie dite arbitrairement directe (non inversée). La borne S correspond également au point 24 de liaison de la résistance Rp1 au transistor de programmation MN1. Une deuxième branche dite droite dans l'orientation de la figure, comporte en série, une deuxième résistance Rp2, un transistor MOS de lecture MNR2 et un transistor MOS de sélection MNS2. L'interconnexion entre la résistance Rp2 et le transistor MNR2 (donc le drain de ce transistor) constitue une deuxième borne NS de sortie inverse par rapport à la borne S. La sortie NS correspond également au point 26 de liaison de la résistance Rp2 au transistor de programmation MN2. La grille du transistor MNR2 est reliée à la borne 24 tandis que la grille du transistor MNR1 est reliée à la borne 26 pour obtenir l'effet d'un bistable. Les grilles des transistors MNS1 et MNS2 sont reliées ensemble à une borne R destinée à recevoir un signal de sélection en lecture de la cellule de comptage. Ce signal correspond, de préférence, au signal de sélection de la cellule de comptage dans un agencement unidirectionnel de plusieurs cellules. Il est alors fourni par le décodeur de colonnes ou de lignes adapté. Dans l'exemple représenté, tous les transistors sont à canal N.

Le fonctionnement en lecture d'une cellule selon ce mode de réalisation est le suivant. Le circuit 25 provoque la commutation du sélecteur K vers le potentiel Vr. De préférence, il s'agit de son état de repos dans la mesure où l'autre état ne sert qu'en programmation (donc, en principe, une seule fois par cellule). La borne d'entrée R reçoit le signal (actif à l'état haut) de sélection (ou de configuration de lecture) de la cellule, rendant conducteur les deux transistors MNS1 et MNS2.

Il en découle qu'une des bornes MNS voit son potentiel croître plus vite que l'autre. Ce déséquilibre provient de la différence de valeur entre les résistances Rp1 et Rp2. Il provoque la conduction d'un des transistors MNR1 et MNR2. En raison du croisement des grilles de ces transistors, celui qui conduit le premier est celui dont la grille participe au chemin électrique (depuis la borne 12) de constante de temps la plus faible (la résistance de valeur la plus faible engendre une constante de temps plus faible), donc celui dont le potentiel de drain croît moins vite que l'autre. Une fois conducteur, ce transistor MNR force son drain (donc la borne de sortie S ou NS correspondante) à la masse 13, ce qui confirme le blocage du transistor MNR de l'autre branche, donc l'état haut sur la borne de sortie correspondante.

La programmation d'une cellule selon ce mode de réalisation s'effectue de la même manière que pour les deux premiers modes de réalisation, à l'aide d'un des transistors MN1 et MN2. Toutefois, les transistors MNS1 et MNS2 de la cellule de comptage doivent être bloqués lors de la programmation (entrée R au niveau bas). Ils servent à protéger les transistors de lecture MNR1 et MNR2 en rendant leurs sources flottantes, évitant ainsi l'apparition de tensions grille-source destructrices en raison de la tension d'alimentation Vp. De plus, en déconnectant les transistors MNR par leurs sources, les transistors MNS empêchent qu'ils voient, entre drain et source, la tension élevée Vp. Par conséquent, les transistors MNR et MNS peuvent être dimensionnés en fonction de la tension de lecture Vr. Seuls les transistors de programmation MN ont besoin d'être dimensionnés pour tenir la tension Vp et supporter le courant relativement élevé (par rapport à la plage de fonctionnement en lecture) servant à programmer la cellule.

Comme pour le mode de réalisation de la figure 3, celui de la figure 5 s'applique également à des transistors MOS à canal P. La transposition du mode de réalisation de la figure 5 à des transistors MOS à canal P est à la portée de l'homme du métier.

Selon une variante de réalisation, on pourra utiliser une seule tension d'alimentation pour la cellule de comptage. On évite ainsi la sélection de la tension d'alimentation entre les niveaux Vp et Vr. Dans ce cas, on choisit une tension d'alimentation suffisante pour imposer la contrainte souhaitée à la programmation des résistances Rp1 et Rp2 (figure 5), ou de la résistance Rp (figures 3 et 4). Les dimensions des transistors sont alors choisies en conséquence.

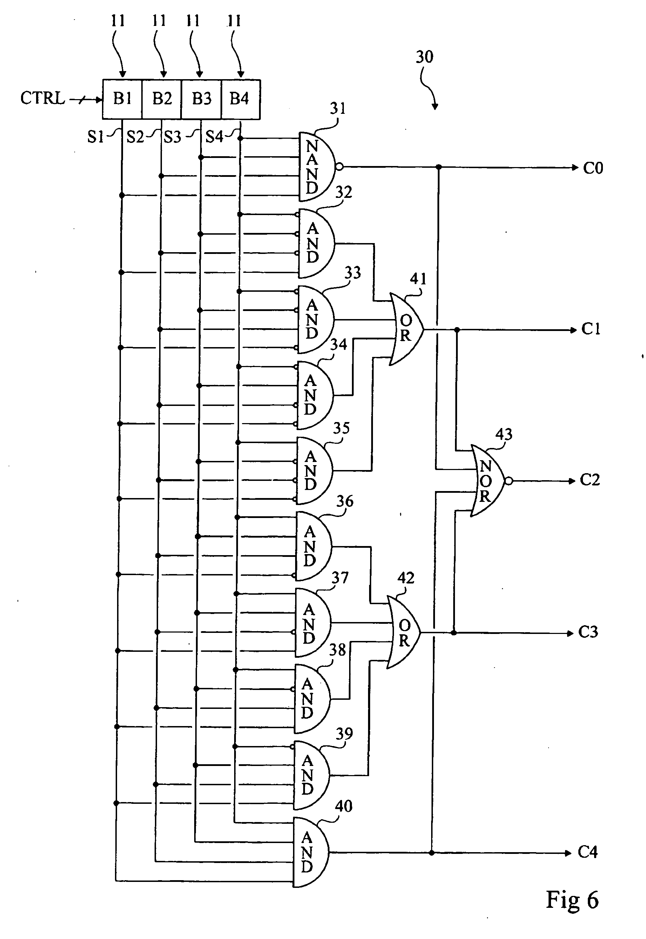

La figure 6 représente un mode de réalisation d'un compteur sur quatre bits associé à son circuit de décodage.

Les quatre bits B1, B2, B3 et B4 du compteur sont individuellement fournis par une cellule 11 (ou 11', ou 11") dont l'élément de stockage est constitué d'au moins une résistance en silicium polycristallin telle que décrite ci-dessus. En figure 6, la structure des cellules de comptage n'a pas été détaillée de même que les différents signaux de commande CTRL en programmation et en sélection. Dans l'exemple de la figure 6, on peut supposer que les quatre bits sont arrangés en une ligne de cellules 11 qui sont toutes lues simultanément pour fournir chacune, sur sa sortie respective S1 à S4, la valeur 0 ou 1 du bit stocké dans la cellule.

Le nombre de cellules à l'état 0 et à l'état 1 est détecté par un circuit 30 de décodage. Ce circuit 30 pourra être réalisé de diverses façons selon l'exploitation faite des résultats de comptage. La figure 6 illustre un exemple pratique pour démontrer la faisabilité d'un tel circuit.

Dans cet exemple, les quatre sorties respectives des cellules de comptage sont reliées aux entrées respectives de dix portes logiques à quatre entrées parmi lesquelles une porte 31 de type NON-ET (NAND) et neuf portes 32 à 40 de type ET (AND). La porte 31 reçoit directement les états des sorties S1 à S4, de même que la porte 40 reçoit directement les états des sorties S1 à S4. Les portes 32 à 35 reçoivent trois des sorties S1 à S4 inversées et la sortie restante en direct, le rang de la sortie directe changeant pour chaque porte. Les portes 36 à 39 reçoivent trois des sorties S1 à S4 directement et la dernière sortie de façon inversée, le rang de la sortie inversée changeant à chacune des portes 36 à 39.

La sortie C0 de la porte 31 indique, par un état haut, le fait que toutes les cellules 11 stockent un état bas, donc un compte à zéro.

Les sorties des portes 32 à 35 sont combinées par une porte 41 de type OU (OR) à quatre entrées dont la sortie fournit un compte C1 indicateur qu'une seule des cellules de comptage est à l'état 1.

Les sorties des portes 36 à 39 sont reliées aux quatre entrées respectives d'une porte 42 de type OU (OR) dont la sortie fournit un compte C3 indicateur que trois des quatre cellules sont à l'état 1.

La sortie de la porte 40 fournit directement un compte C4 indicateur d'un état 1 des quatre cellules.

Les sorties respectives des portes 31, 41, 42 et 40 sont combinées par une porte 43 de type NON-OU (NOR) dont la sortie fournit un compte C2 indicateur que deux des cellules sont à l'état 1.

Du circuit 30 de décodage ci-dessus on voit bien qu'avec quatre cellules de comptage à résistance en silicium polycristallin, on est capable d'obtenir cinq états de comptage (de 0 à 4). Pour chaque cellule de comptage 11 supplémentaire, on ajoute une unité de compte.

Un avantage de la présente invention est qu'elle permet la réalisation d'un compteur monotone parfaitement fiable et dont la programmation ne s'accompagne pas d'une destruction des cellules de comptage.

Un autre avantage de la présente invention est que le compte stocké dans l'ensemble de cellules de comptage est invisible, en ce sens qu'il n'est pas détectable optiquement comme ce serait le cas pour un compteur réalisé à partir de cellules fusibles. Cet avantage et le caractère irréversible du compteur sont particulièrement intéressants dans des applications sécuritaires.

L'exemple de la figure 6 montre le cas d'un compteur monotone croissant. On notera toutefois que, selon le circuit de décodage utilisé, on peut obtenir un compte décroissant.

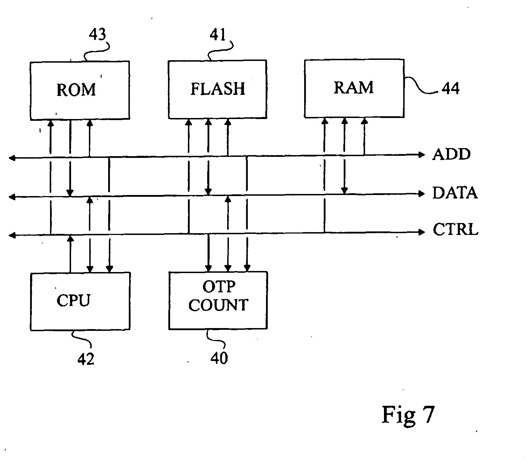

La figure 7 illustre un exemple d'application d'un compteur 40 selon l'invention dans un circuit utilisant une mémoire flash 41. En figure 7, on s'est contenté de représenter une unité centrale de traitement 42, dont au moins une partie d'un programme de fonctionnement est stocké dans une mémoire à lecture seule 43 (ROM), dont au moins des données sont stockées dans une mémoire vive 44 (RAM), ainsi que trois bus partagés d'adresse ADD, de données DATA et de commande CTRL.

Les différents éléments 40 à 44 communiquent entre eux par l'intermédiaire des bus d'adresse, de données et de commande. Dans cet exemple d'application, le compteur 40 (OTP COUNT) de l'invention sert à décompter ou compter des événements de façon irréversible, à la place de ce qui est effectué classiquement par une mémoire flash 41. Un avantage notable est alors que le comptage 40 s'effectue bit à bit, ce qui requiert une surface nettement moins importante que la programmation d'une mémoire flash de façon irréversible.

Un autre avantage de l'invention est qu'à la différence d'une programmation de mémoire flash qui est réversible, le compteur de l'invention apporte une irréversibilité de la programmation effectuée.

Bien entendu, la présente invention est susceptible de diverses variantes et modifications qui apparaîtront à l'homme de l'art. En particulier, celle-ci s'applique quelle que soit l'exploitation faite du compte obtenu. De plus, les dimensions à donner aux différentes résistances, transistors et potentiels d'alimentation et de lecture sont à la portée de l'homme du métier à partir des indications fonctionnelles données ci-dessus et de l'application souhaitée. En outre, le nombre de bits prévus dans le compteur n'est pas limité. Enfin, d'autres structures de cellules de comptage que celles illustrées aux figures 3 à 5, peuvent être envisagées pourvu de respecter le recours à au moins un élément de mémorisation résistif en silicium polycristallin, programmable par diminution irréversible de sa valeur. On pourra notamment s'inspirer d'une structure de cellule mémoire classique, en l'adaptant à l'utilisation d'un tel élément de mémorisation.

## Revendications

1. Compteur monotone réalisé en circuit intégré, **caractérisé en ce que** chaque bit de comptage est fourni par une cellule mémoire (11, 11' ; 11'') contenant au moins un élément de ' mémorisation (Rp ; Rp1, Rp2) constitué d'une résistance en silicium polycristallin, programmable par diminution irréversible de sa valeur, rendant la variation du comptage irréversible.

2. Compteur selon la revendication 1, **caractérisé en ce que** la programmation de ladite résistance (Rp ; Rp1, Rp2) est effectuée en la soumettant temporairement à un courant de contrainte supérieur à un courant pour lequel sa valeur présente un maximum.

3. Compteur selon la revendication 1 ou 2, **caractérisé en ce qu'**il comporte un circuit (30) de décodage des états contenus dans lesdites cellules mémoire (11, 11' ; 11'') pour fournir le compte résultant.

4. Compteur selon l'une quelconque des revendications 1 à 3, **caractérisé en ce que** chaque cellule mémoire (11'') comporte, en parallèle entre deux bornes (12, 13) d'application d'une tension d'alimentation (Vp, Vr), deux branches comprenant chacune

   une première résistance de programmation (Rp1, Rp2) en silicium polycristallin, connectée entre une première borne d'alimentation (12) et une borne de lecture différentielle (24, 26) de l'état de la cellule mémoire ; et chaque cellule mémoire comprend
   au moins un interrupteur de programmation (MN1, MN2) reliant une desdites bornes de lecture à la deuxième borne d'alimentation (13).

5. Compteur selon la revendication 4, **caractérisé en ce que** chaque branche comporte un interrupteur de programmation.

6. Compteur selon la revendication 4 ou 5, **caractérisé en ce que** lesdites résistances de programmation (Rp1, Rp2) sont deux résistances en silicium polycristallin identiques en taille et en dopage éventuel.

7. Compteur selon l'une quelconque des revendications 1 à 4, **caractérisé en ce que** chaque cellule mémoire (11, 11') comporte un transistor de programmation (MN, MP) en série avec une résistance de programmation (Rp).

8. Compteur selon l'une quelconque des revendications 1 à 7, **caractérisé en ce qu'**il comporte en outre un circuit de commande en programmation de chacune des cellules mémoire (11, 11' ; 11''), propre à fournir des signaux de commande individuels aux interrupteurs de programmation.

## Claims

1. A monotonic counter formed as an integrated circuit, **characterized in that** each counting bit is provided by a memory cell (11, 11'; 11'') containing at least one storage element (Rp; Rp1, Rp2) formed of a polysilicon resistor, programmable by irreversible decrease in its value, making the counting variation irreversible.

**2.** The counter of claim 1, **characterized in that** the programming of said resistor (Rp; Rp1, Rp2) is performed by temporarily submitting it to a constraint current greater than a current for which its value exhibits a maximum.

**3.** The counter of claim 1 or 2, **characterized in that** it comprises a circuit (30) for decoding the states contained in said memory cells (11, 11'; 11") for providing the resulting count.

**4.** The counter of any of claims 1 to 3, **characterized in that** each memory cell (11") comprises, in parallel between two terminals (12, 13) of application of a supply voltage (Vp, Vr), two branches each comprising a first polysilicon programming resistor (Rp1, Rp2) connected between a first supply terminal (12) and a terminal of differential reading (24, 26) of the memory cell state; and each memory cell comprises:

   at least one programming switch (MN1, MN2) connecting one of said read terminals to the second supply terminal (13).

**5.** The counter of claim 4, **characterized in that** each branch comprises a programming switch.

**6.** The counter of claim 4 or 5, **characterized in that** said programming resistors (Rp1, Rp2) are two polysilicon resistors identical in size and in possible doping.

**7.** The counter of any of claims 1 to 4, **characterized in that** each memory cell (11, 11') comprises a programming transistor (MN, MP) in series with a programming resistor (Rp).

**8.** The counter of any of claims 1 to 7, **characterized in that** it further comprises a circuit for controlling the programming of each of the memory cells (11, 11'; 11"), capable of providing individual control signals to the programming switches.

**Patentansprüche**

**1.** Ein monotoner Zähler, der als eine integrierte Schaltung gebildet ist, **dadurch gekennzeichnet, dass** jedes Zähl-Bit durch eine Speicherzelle (11, 11'; 11") vorgesehen ist, die mindestens ein Speicherelement (Rp; Rp1, Rp2) enthält, das aus einem Widerstand aus polykristallinem Silizium gebildet ist, das durch eine irreversible Verringerung seines Werte programmierbar ist, was die Zählvariation irreversible macht

**2.** Zähler nach Anspruch 1, **dadurch gekennzeichnet dass**, die Programmierung des Widerstands (Rp; Rp1, Rp2) durchgeführt wird, dadurch dass er temporär einen eingeprägten Strom bzw einem Zwangsstrom unterworfen wird, der größer ist als ein Strom für den sein Wert ein Maximum darstellt.

**3.** Zähler nach Anspruch 1 oder 2, **dadurch gekennzeichnet, dass** er eine Schaltung (30) aufweist zum Decodieren der Zustände die in den Speicherzellen (11, 11'; 11") enthalten sind, um die resultierende Zählung vorzusehen

**4.** Zähler nach irgendeinem der Ansprüche 1 bis 3, **dadurch gekennzeichnet, dass** jede Speicherzelle (11") parallel zwischen den zwei Anschlüssen (12, 13) zum Anlegen einer Versorgungsspannung (Vp, Vr) zwei Zweige aufweist, die jeweils einen ersten Programmierungswiderstand (Rp1, Rp2) aus polykristallinen Silizium aufweisen, der zwischen einem ersten Versorgungsanschluss (12) und einem Anschluss zum differentiellen Ablesen (24, 26) des Speicherzellenzustands verbunden ist; und jede Speicherzelle Folgendes aufweist:

   mindestens einen Programmierungsschalter (MN1, MN2) der einen der Leseanschlüsse mit dem zweiten Versorgungsanschluss (13) verbindet

**5.** Zähler nach Anspruch 4, **dadurch gekennzeichnet dass** jeder Zweig einen Programmierungsschalter aufweist.

**6.** Zähler nach Anspruch 4 oder 5, **dadurch gekennzeichnet, dass** die Programmierungswiderstände (Rp1, Rp2) zwei Widerstände aus polykristallinem Silizium sind, die identisch bezüglich der Größe und bezüglich der möglichen Dotierung sind.

**7.** Zähler nach irgendeinem der Ansprüche 1 bis 4, **dadurch gekennzeichnet, dass** jede Speicherzelle (11, 11') einen Programmierungstransistor (MN, MP) aufweist, der in Reihe geschaltet ist, mit einem Programmierungswiderstand (Rp).

**8.** Zähler nach irgendeinem der Ansprüche 1 bis 7, **dadurch gekennzeichnet, dass** er ferner eine Schaltung aufweist, zum Steuern der Programmierung von jeder der Speicherzellen (11, 11'; 11"), die geeignet ist individuelle Steuersignale für die Programmierungsschalter vorzusehen

Fig 1

Fig 2

Fig 3

Fig 4

Fig 5

Fig 6

Fig 7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4559637 A
- US 5418738 A